# EUROPEAN PATENT APPLICATION

(11) **EP 4 646 062 A1**
(43) Date of publication of application: **05.11.2025**
(21) Application number: 25170906.9
(22) Date of filing: 16.04.2025
(51) Int. Cl.: H10F 10/19, H10F 71/00

(54) **SOLAR CELL, TANDEM CELL AND PHOTOVOLTAIC MODULE**

(30) Priority: 29.04.2024 CN 202410533442; 29.04.2024 CN 202410533127
(71) Applicant: Jinko Solar (Shangrao) Co., Ltd, Shangrao, Jiangxi (CN); Jinko Solar (Haining) Co., Ltd., Haining City, Zhejiang 314415 (CN)
(72) Inventor: ZHENG, Jingming, SHANGRAO (CN); WANG, Zhao, SHANGRAO (CN); LI, Xian, SHANGRAO (CN); YANG, Ouyang, SHANGRAO (CN); ZHENG, Peiting, SHANGRAO (CN); YANG, Jie, SHANGRAO (CN); ZHANG, Xinyu, SHANGRAO (CN)
(74) Representative: Botti & Ferrari S.p.A.

(57) **Abstract**

The present disclosure relates to a solar cell, a tandem cell and a photovoltaic module. The solar cell (100) includes a substrate (1), an emitter (2), a doped conductive layer (3), a first electrode (4), a second electrode (5) and an extended doped layer (6). The substrate includes a first surface and a second surface opposite to each other. Along a thickness direction of the substrate, the emitter (2) is formed in or on the first surface of the substrate. Along the thickness direction of the substrate, the doped conductive layer (3) is formed in or on the second surface of the substrate. The first electrode (4) is formed on a surface of the emitter (2) away from the substrate and electrically connected to the emitter (2). The second electrode (6) is formed on a surface of the doped conductive layer (3) away from the substrate and electrically connected to the doped conductive layer (3). Along a direction perpendicular to the thickness direction, the extended doped layer (6) is formed on at least one side surface of the substrate, and the extended doped layer (6) has the same type of doping elements as the doped conductive layer (3) or the emitter (2). A high-low junction or a P-N junction is formed between the extended doped layer (6) and the substrate (1), so that there is a relatively high leakage current at the extended doped layer (6), enabling flowing of the current in an abnormal state, so that the photovoltaic module can keep working normally.

## Description

### TECHNICAL FIELD

The present disclosure relates to the field of photovoltaic cell technologies, and in particular relates to a solar cell, a tandem cell and a photovoltaic module.

### BACKGROUND

A solar cell is a photovoltaic semiconductor wafer that directly generates electricity by utilizing sunlight, which is also known as a "solar chip" or a "photovoltaic cell". When irradiated by light under certain illuminance conditions, the solar cell can instantly output voltage and generate a current when a circuit loop is formed. A photovoltaic module usually includes a plurality of solar cells, and the solar cells are connected to form a solar cell string. In practical applications, if an abnormal occurs in one of the solar cells, resulting in decrease of in the current of this solar cell, the current of the entire solar cell string will be restricted, which may easily lead to reduction of the power of the photovoltaic module, making it difficult to maintain the normal working state.

### SUMMARY

In view of this, the present disclosure provides a solar cell, a tandem cell and a photovoltaic module, to help solve the problem in the related art that when the current of a certain solar cell of a solar cell string decreases due to abnormal, the current of the solar cell string may be restricted.

The first aspect of the present disclosure provides a solar cell. The solar cell includes a substrate, an emitter, a doped conductive layer, a first electrode, a second electrode and an extended doped layer. The substrate includes a first surface and a second surface opposite to each other. Along a thickness direction of the substrate, the emitter is formed in or on a surface of the substrate. Along the thickness direction of the substrate, the doped conductive layer is formed in or on the second surface of the substrate. The first electrode is formed on a surface of the emitter away from the substrate and electrically connected to the emitter. The second electrode is formed on a surface of the doped conductive layer away from the substrate and electrically connected to the doped conductive layer. Along a direction perpendicular to the thickness direction, the extended doped layer is formed on at least one side surface of the substrate, and the extended doped layer and the doped conductive layer or the emitter have a doping element of the same type.

In one or more embodiments, an end of the extended doped layer close to the doped conductive layer is connected to the doped conductive layer.

In one or more embodiments, the extended doped layer and the doped conductive layer are integrally formed.

In one or more embodiments, a gap is provided between the emitter and an end of the extended doped layer close to the emitter.

In one or more embodiments, an end of the extended doped layer close to the emitter is connected to the emitter.

In one or more embodiments, the extended doped layer and the emitter are integrally formed.

In one or more embodiments, the a gap is formed between an end of the extended doped layer close to the doped conductive layer and the doped conductive layer.

In one or more embodiments, along the thickness direction of the substrate, a gap is respectively provided between one of two ends of the extended doped layer and the emitter and between the other one of the two ends of the extended doped layer and the doped conductive layer.

In one or more embodiments, a distance dimension of the gap is in a range of 0.5µm to 10µm.

In one or more embodiments, a thickness of the extended doped layer is d, and 0.05µm ≤ d ≤ 5µm.

In one or more embodiments, the extended doped layer and the doped conductive layer have doping elements of the same type, and the doping element in the extended doped layer and the doping element in the doped conductive layer have similar doping concentration.

In one or more embodiments, the doping concentration of the doping element in the extended doped layer is 1≤10¹⁷ atoms/cm³ to 5≤10²¹ atoms/cm³.

In one or more embodiments, the solar cell further includes a first passivation layer and a second passivation layer. The first passivation layer is formed on a surface of the emitter away from the substrate. An edge of the first passivation layer extends to a part of a surface of the extended doped layer away from the substrate. The second passivation layer is formed on a surface of the doped conductive layer away from the substrate. An edge of the second passivation layer extending to another part of the surface of the extended doped layer away from the substrate.

In one or more embodiments, the solar cell further includes a tunneling layer. The tunneling layer is formed between the substrate and the doped conductive layer as well as between the substrate and the extended doped layer.

The second aspect of the present disclosure provides a tandem cell. The tandem cell includes a bottom cell, a top cell and an intermediate connection layer. The bottom cell is the solar cell according to any of the above embodiments. The top cell is one of a perovskite cell, a donor-acceptor cell, a cadmium telluride solar cell, a copper indium gallium selenide solar cell or a gallium arsenide solar cell. The intermediate connection layer is electrically connected between the bottom cell and the top cell.

The third aspect of the present disclosure provides a photovoltaic module. The photovoltaic module includes at least one solar cell string, an encapsulation layer and a cover plate. The at least one solar cell string is formed by connecting a plurality of solar cells according to any of the above embodiments. The encapsulation layer is configured to cover a surface of the at least one solar cell string, and the cover plate is configured to cover a surface of the encapsulation layer away from the at least one solar cell string.

It should be understood that the above general description and the following detailed description are only exemplary and cannot limit the present disclosure.

### BRIEF DESCRIPTION OF DRAWINGS

In order to better illustrate the technical solutions of the embodiments of the present disclosure, a brief introduction will be provided to the drawings to be used in the embodiments below. It is appreciated that, the drawings in the following description are just some embodiments of the present disclosure. For those of ordinary skill in the art, other drawings may also be obtained based on these drawings without creative efforts.
FIG. 1a is a schematic structural diagram of a solar cell according to one or more embodiments of the present disclosure.
FIG. 1b is a schematic structural diagram of a solar cell according to one or more embodiments of the present disclosure.
FIG. 2a is a schematic structural diagram of a solar cell according to one or more embodiments of the present disclosure.
FIG. 2b is a schematic structural diagram of a solar cell according to one or more embodiments of the present disclosure.
FIG. 3a is a schematic structural diagram of a solar cell according to one or more embodiments of the present disclosure.
FIG. 3b is a schematic structural diagram of a solar cell according to one or more embodiments of the present disclosure.
FIG. 4 is a schematic structural diagram of a solar cell according to one or more embodiments of the present disclosure.
FIG.5 is a schematic structural diagram of a solar cell according to one or more embodiments of the present disclosure.
FIG. 6a is a schematic structural diagram of a solar cell according to one or more embodiments of the present disclosure.
FIG. 6b is a schematic structural diagram of a solar cell according to one or more embodiments of the present disclosure.
FIG. 7 is a schematic structural diagram of a tandem cell according to one or more embodiments of the present disclosure.
Figure 8 is a schematic structural diagram of a photovoltaic module according to one or more embodiments of the present disclosure.

The drawings here are incorporated into the specification and constitute a part of the specification, showing the embodiments in line with the present disclosure and are used together with the specification to explain the principles of the present disclosure.

### DESCRIPTION OF EMBODIMENTS

In order to better understand the technical solutions of the present disclosure, embodiments of the present disclosure will be described in detail below in combination with the drawings.

In the description of the present disclosure, unless otherwise clearly stipulated and defined, the terms "first" and "second" are only used for descriptive purposes and shall not be understood as indicating or implying relative importance. Unless otherwise specified or explained, the term "plurality" refers to two or more. Terms such as "connection" and "fixation" should be understood in a broad sense. For example, "connection" may be a fixed connection, a detachable connection, an integral connection, or an electrical connection. "Connection" may also be directly connected or indirectly connected through an intermediate medium. For those of ordinary skill in the art, the specific meanings of the above terms in embodiments of the present disclosure can be understood according to specific circumstances.

The terms used in the embodiments of the present disclosure are only for the purpose of describing specific embodiments and are not intended to limit the present disclosure. The singular forms "a/an", "said" and "the" used in the embodiments of the present disclosure and the appended claims are also intended to include the plural forms unless the context clearly indicates otherwise.

It should be understood that the term "and/or" used herein is merely an associative relationship describing related objects, indicating that there may be three relationships. For example, "A and/or B" may mean: A alone exists, both A and B exist simultaneously, and B alone exists. In addition, the character "/" generally indicates an "or" relationship between the related objects.

It should be noted that the orientation terms such as "above", "below", "left" and "right" described in the embodiments of the present disclosure are described from the perspective shown in the drawings and should not be understood as limitations on the embodiments of the present disclosure. In addition, in the context, it should also be understood that when it is mentioned that one element is connected "above" or "below" another element, it may not only be directly connected "above" or "below" another element, but also indirectly connected "above" or "below" another element through an intermediate element.

A photovoltaic module usually includes multiple solar cells, and the multiple solar cells are connected to form a solar cell string. In practical applications, if abnormal occurs in one of the solar cells, resulting in decrease of the current of this solar cell, the current of the solar cell string may be restricted, which will easily lead to reduction of the power of the photovoltaic module, making it difficult to maintain the normal working state.

In view of this, the present disclosure provides a solar cell, a tandem cell and a photovoltaic module, which can ensure the current of a solar cell string flows normally when abnormal occurs in a certain solar cell of the solar cell string, avoiding the decrease of the current of the solar cell string, and thus ensuring that the photovoltaic module can maintain the normal working state. The solar cell may be applied to various cell structures, including but not limited to a tunnel oxide passivated contact (TOPCon) cell, an interdigitated back contact (IBC) cell, a passivated emitter rear cell (PERC), etc., and there is no limitation here.

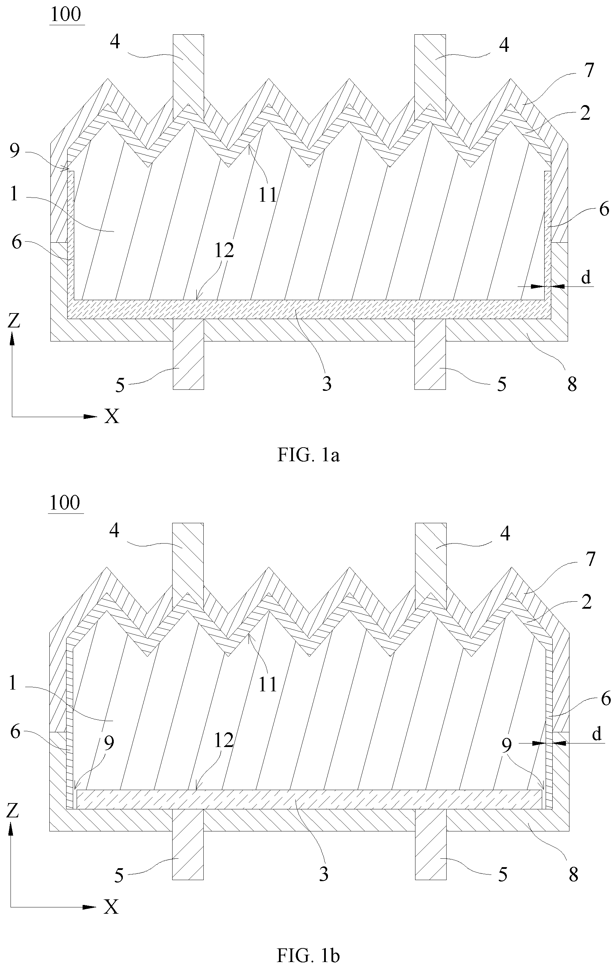

As shown in FIG. 1a and FIG. 1b, the solar cell 100 includes a substrate 1, an emitter 2, a doped conductive layer 3, a first electrode 4, a second electrode 5 and an extended doped layer 6.

As shown in FIG. 1a and FIG. 1b, the substrate 1 has a first surface 11 and a second surface 12 which are oppositely arranged. The substrate 1 is used to receive incident light and generate photo-generated carriers. In some embodiments, the substrate 1 is a silicon substrate and may include one or more of monocrystalline silicon, polycrystalline silicon, amorphous silicon or microcrystalline silicon. In some other embodiments, the materials of the substrate 1 may also be silicon carbide, organic materials or multi-component compounds. Multi-component compounds may include but are not limited to materials such as perovskite, gallium arsenide, cadmium telluride, copper indium selenide, etc. As an example, in some embodiments of the present disclosure, the substrate 1 is a monocrystalline silicon substrate. The substrate 1 contains doping elements, and the type of the doping elements may be N-type or P-type. N-type elements may be Group V elements such as phosphorus (P) element, bismuth (Bi) element, antimony (Sb) element or arsenic (As) element, etc. P-type elements may be Group III elements such as boron (B) element, aluminium (Al) element, gallium (Ga) element or indium (In) element, etc. For example, when the substrate 1 is a P-type silicon substrate, the type of its internal doping elements is P-type. For another example, when the substrate 1 is an N-type silicon substrate, the type of its internal doping elements is N-type. In embodiments of the present disclosure, the substrate 1 is an N-type silicon substrate as an example, to improve the conversion efficiency of the solar cell 100 and reduce the manufacturing costs.

Along a thickness direction Z of the substrate 1, the emitter 2 is formed on a surface of the substrate 1 away from the second surface 12. That is, the emitter 2 is formed on the first surface 11 of the substrate 1. For example, the emitter 2 may be formed inside or above the first surface 11 of the substrate 1. The emitter 2 has a different conductive type of doping elements from that in the substrate 1, so that they may jointly form a PN junction structure. As an example, when the substrate 1 is an N-type silicon substrate, the emitter 2 may be a P-type emitter. As another example, when the substrate 1 is a P-type silicon substrate, the emitter 2 may be an N-type emitter. In addition, the emitter 2 may be formed by diffusing doping elements into the substrate 1 on the first surface 11 of the substrate 1. For example, when the substrate 1 is an N-type silicon substrate, a P-type emitter 2 may be formed by diffusing boron into the substrate 1. The emitter 2 may also be made of doped polycrystalline silicon, microcrystalline silicon or amorphous silicon with a type of doping elements opposite to that of the substrate 1. For example, when the substrate 1 is an N-type silicon substrate, a tunneling layer and a doped polycrystalline silicon, microcrystalline silicon or amorphous silicon layer may be formed on the first surface 11 of the substrate 1 by means of low pressure chemical vapor deposition (LPCVD) or plasma enhanced chemical vapor deposition (PECVD), etc. P-type doping elements are doped into the polycrystalline silicon layer, microcrystalline silicon layer or amorphous silicon layer to form the emitter 2.

Along the thickness direction Z of the substrate 1, the doped conductive layer 3 is provided on the second surface 12. For example, the doped conductive layer 3 may be formed inside or above the second surface 12 of the substrate 1. The doped conductive layer 3 may serve as a field passivation layer, thereby improving the passivation effect on the second surface 12 of the substrate 1. The doping elements in the doped conductive layer 3 are the same as those in the substrate 1 and a concentration difference is formed with the substrate 1, thus forming a high-low junction, enabling the doped conductive layer 3 to form good contact with the metal electrode and capable of forming energy band bending on the second surface 12 of the substrate 1 to achieve selective transmission of carriers and reduce loss due to recombination. For example, any one of physical vapor deposition, chemical vapor deposition, plasma enhanced chemical vapor deposition, and atomic layer deposition may be used to deposit on the second surface 12 to form a tunneling layer and a doped polycrystalline silicon, microcrystalline silicon or amorphous silicon layer, thereby forming the doped conductive layer 3. For example, the doped conductive layer 3 may also be directly formed by diffusing the doping elements into the substrate 1 on the second surface 12 of the substrate 1. The diffusion depth of the doping elements is about 200 nm, which may be set according to actual requirements and is not limited here.

The first electrode 4 is provided on a surface of the emitter 2 away from the substrate 1, and the first electrode 4 is electrically connected to the emitter 2. As an example, the first electrode 4 may be in contact with the emitter 2 in a direct or indirect manner to form an electrical connection. The first electrode 4 is used to collect and converge the current of the solar cell 100. The first electrode 4 may be prepared by screen printing and sintering. In some embodiments, the metal paste used to prepare the first electrode 4 may be one or more of aluminium, silver, gold, nickel, molybdenum and copper, and there is no limitation here.

The second electrode 5 is provided on a surface of the doped conductive layer 3 away from the substrate 1, and the second electrode 5 is electrically connected to the doped conductive layer 3. As an example, the second electrode 5 may be in contact with the doped conductive layer 3 in a direct or indirect manner to form an electrical connection. The second electrode 5 is used to collect and converge the current of the solar cell 100. The second electrode 5 may be prepared by screen printing and sintering. In some embodiments, the metal paste used to prepare the second electrode 5 may be one or more of aluminium, silver, gold, nickel, molybdenum and copper, and there is no limitation here.

As shown in FIG. 1a and FIG. 1b, along a direction perpendicular to the thickness direction Z, the extended doped layer 6 is provided on at least one side surface of the substrate 1, and the extended doped layer 6 has doping elements with the same conductive type as the doped conductive layer 3 or the emitter 2.

In some embodiments, as shown in FIG. 1a, the extended doped layer 6 has doping elements with the same conductive type as the doped conductive layer 3. For example, when the substrate 1 is an N-type silicon substrate, the doped conductive layer 3 is an N-type doped layer, and the conductive type of the doping elements in the extended doped layer 6 is a N-type. As another example, when the substrate 1 is a P-type silicon substrate, the doped conductive layer 3 is a P-type doped layer, and the conductive type of the doping elements in the extended doped layer 6 is a P-type.

In some embodiments, the doping elements in the extended doped layer 6 may be the same as those in the doped conductive layer 3 to facilitate the preparation and formation of the extended doped layer 6. In some other embodiments, the doping elements in the extended doped layer 6 may also be different from those in the doped conductive layer 3 to further improve the design freedom of the extended doped layer 6 and meet the design requirements of different solar cells 100. As long as it is ensured that the doping elements in the extended doped layer 6 and the doping elements in the doped conductive layer 3 have the same conductive type, for example, both are P-type doping elements or both are N-type doping elements, and there is no limitation here.

In some embodiments, as shown in FIG. 1b, the extended doped layer 6 has doping elements with the same conductive type as the emitter 2. For example, when the substrate 1 is an N-type silicon substrate, the emitter 2 is a P-type emitter, and the conductive type of the doping elements in the extended doped layer 6 is a P-type. As another example, when the substrate 1 is a P-type silicon substrate, the emitter 2 is an N-type emitter, and the conductive type of the doping elements in the extended doped layer 6 is an N-type.

In some embodiments, the doping elements in the extended doped layer 6 may be the same as those in the emitter 2, for example both are boron elements of P-type, to facilitate the preparation and formation of the extended doped layer 6. In some other embodiments, the doping elements in the extended doped layer 6 may also be different from those in the emitter 2 to further improve the design freedom of the extended doped layer 6 and meet the design requirements of different solar cells 100. As long as it is ensured that the doping elements in the extended doped layer 6 and the doping elements in the emitter 2 have the same conductive type, for example, both are P-type doping elements or both are N-type doping elements, and there is no limitation here.

It should be noted that the extended doped layer 6 may be formed in any direction perpendicular to the thickness direction Z. In embodiments of the present disclosure, the direction perpendicular to the thickness direction Z is taken as the first direction X for illustration. Further, the first direction X may be the length direction or the width direction of the substrate 1, and there is no limitation here.

In some embodiments of the present disclosure, as shown in FIG. 1a and FIG. 1b, the extended doped layer 6 is provided on at least one side surface of the substrate 1, so that the solar cell 100 can generate leakage current at the extended doped layer 6. Moreover, since the extended doped layer 6 is provided on the side surface of the substrate 1 perpendicular to the thickness direction Z, it will not affect the current transmission of the solar cell 100 under the normal working state, thereby ensuring the overall output power of the solar cell string and the photovoltaic module where the solar cell 100 is located.

In addition, when the conductive type of the doping elements in the extended doped layer 6 is the same as those in the doped conductive layer 3, a high-low junction can be formed between the extended doped layer 6 and the substrate 1, so that carriers can generate additional recombination at the extended doped layer 6, which is conducive to improving the leakage current and the current transmission efficiency at the extended doped layer 6. When the conductive type of the doping elements in the extended doped layer 6 is the same as those in the emitter 2, the conductive type of the doping elements in the extended doped layer 6 is different from those in the substrate 1. A P-N junction can be formed between the extended doped layer 6 and the substrate 1, so that carriers can generate additional recombination at the extended doped layer 6, which is conducive to improving the leakage current and the current transmission efficiency at the extended doped layer 6. As a result, when the conductive type of the doping elements in the extended doped layer 6 is the same as those in the doped conductive layer 3 or the emitter 2, it is possible to make the leakage current at the extended doped layer 6 relatively high to reach more than 1 A. Thus, when the solar cell 100 is in an abnormal state (for example, when the solar cell has a hot spot phenomenon due to being shaded or fragmented), it may play the role of a resistive device, thereby ensuring that the current of the solar cell string where the solar cell 100 is located can flow normally, to avoid a large power loss of the photovoltaic module caused by the decrease in the current of the solar cell string where the solar cell 100 is located, thus ensuring that the photovoltaic module may keep working under the condition that only the power of the abnormal solar cell 100 is lost, maintaining a stable high-power output and a normal working state, and preventing the power of the photovoltaic module from dropping sharply due to the local hot spot phenomenon of the solar cell 100.

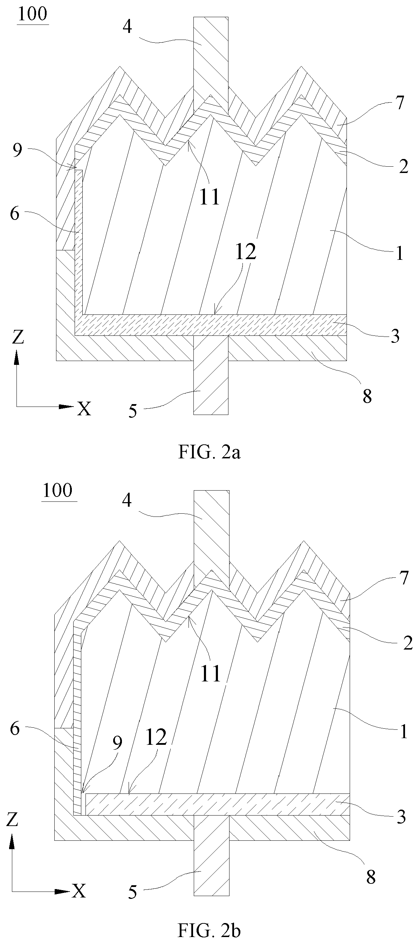

As shown in FIG. 1 and FIG. 2, the range of the leakage current at the extended doped layer 6 of the solar cell 100 according to some embodiments of the present disclosure may reach the range of 1A to10A. Thus, when an abnormal problem occurs in the solar cell 100, it can enable the solar cell string and the photovoltaic module where the solar cell 100 is located to work normally. Moreover, the current transmission performance of the solar cell 100 under the normal working state can be ensured.

The solar cell 100 may be an whole solar cell without being cut as shown in FIG. 1. The solar cell 100 may also be a half-cut solar cell or a segmented solar cell formed by cutting a prepared whole solar cell into halves, thirds or even smaller dimensions along the thickness direction Z as shown in FIG. 2, and there is no limitation here. When the solar cell 100 is a half-cut solar cell or a segmented solar cell, the extended doped layer 6 may not be provided on its cutting surface.

In addition, the extended doped layer 6 may be formed by diffusing doping elements into the substrate 1 on the side surface of the substrate 1. It is understandable that, it may also be formed by doped polycrystalline silicon, microcrystalline silicon or amorphous silicon with the same conductive type of doping elements as the doped conductive layer 3 or the emitter 2 on the side surface of the substrate 1. Its preparation process may be similar as that of the doped conductive layer 3 or the emitter 2, which may be determined according to practical requirements, and there is no limitation here.

It should be noted that along the thickness direction Z of the substrate 1, one end of two ends of the extended doped layer 6 is connected to the adjacent doped conductive layer 3 or emitter 2, and the other end of the two ends has a gap 9 with the adjacent emitter 2 or doped conductive layer 3. The two ends of the extended doped layer 6 may also be respectively connected to the adjacent doped conductive layer 3 or emitter 2. The two ends of the extended doped layer 6 may also respectively have a gap 9 with the adjacent doped conductive layer 3 or emitter 2, so as to improve the structural design freedom of the solar cell 100. It may be specifically designed according to actual requirements, and there is no limitation here. The following will be illustrated through specific embodiments.

In some embodiments, as shown in FIG. 2a and FIG. 2b, an end of the extended doped layer is connected to an adjacent doped conductive layer 3 or emitter 2, and a gap is formed between the other end of the extended doped layer and the emitter 2 or the doped conductive layer 3.

When the conductive type of the doping elements in the extended doped layer 6 is the same as those in the doped conductive layer 3, as shown in FIG. 2a, the end of the extended doped layer 6 close to the doped conductive layer 3 is connected to the doped conductive layer 3.

In some embodiments, as shown in FIG. 2a, the connection between the end of the extended doped layer 6 close to the doped conductive layer 3 and the doped conductive layer 3 can improve the current transmission efficiency of the solar cell 100 in an abnormal state, thereby further ensuring that the current of the solar cell string where the solar cell 100 is located can flow normally, so as to ensure that the photovoltaic module may keep working under the condition that only the power of the abnormal solar cell 100 is lost and maintain the normal working state.

In some embodiments, as shown in FIG. 2a, when the conductive type of the doping elements in the extended doped layer 6 is the same as those in the doped conductive layer 3, the extended doped layer 6 and the doped conductive layer 3 are integrally formed, that is, the extended doped layer 6 and the doped conductive layer 3 may be formed through the same process, which can reduce the process flow, thereby improving the preparation efficiency of the solar cell 100, facilitating the mass production of solar cells and saving costs.

For example, the substrate 1 is an N-type silicon substrate and the doped conductive layer 3 is an N-type doped layer. In the process of preparing the solar cell 100, first, the cell with phosphorus silicon glass (PSG) on the surface of the prepared doped conductive layer 3 may be subjected to single-sided HF acid washing. By controlling the acid washing process, only the contact surface with the liquid, that is, the first surface 11 of the substrate 1, is washed during the acid washing process, while 10% - 100% of the phosphorus silicon glass (PSG) on the side surface is retained. Further, the area on the first surface 11 without the protection of phosphorus silicon glass (PSG) may be etched to remove the unnecessary N-type doped layer. In addition, the doped conductive layer 3 is formed on the second surface 12 of the substrate 1 and the extended doped layer 6 is formed on the side of the substrate 1. The preparation process is simple and easy to implement, which further facilitates the mass production of solar cells and saves costs.

It is understandable that, the extended doped layer 6 may also be separately prepared from the doped conductive layer 3, which further improves the design freedom of the extended doped layer 6, facilitates the adjustment of the depth and concentration of the doping elements in the extended doped layer 6, thereby adjusting the leakage current at the extended doped layer 6, improving the leakage effect of the solar cell 100 and meeting the design requirements of the solar cell 100. The configuration may be specifically set according to actual requirements, and there is no limitation here.

In some embodiments shown in FIG. 2a, when the conductive type of the doping elements in the extended doped layer 6 is the same as those in the doped conductive layer 3, along the thickness direction Z, the extended doped layer 6 may be only connected to the doped conductive layer 3. That is, the end of the extended doped layer 6 close to the doped conductive layer 3 is connected to the doped conductive layer 3, and there is a gap 9 between the end of the extended doped layer 6 close to the emitter 2 and the emitter 2.

In some embodiments, as shown in FIG. 2a, the existence of the gap 9 between the end of the extended doped layer 6 close to the emitter 2 and the emitter 2 can ensure that the solar cell 100 has a high current transmission effect in an abnormal state, while avoiding the influence of the extended doped layer 6 on the emitter 2, so as to ensure the current transmission performance of the solar cell 100 under the normal working state, thereby ensuring the performance of the solar cell 100.

In some embodiments, when the conductive type of the doping elements in the extended doped layer 6 is the same as those in the doped conductive layer 3, along the thickness direction Z of the substrate 1, the extended doped layer 6 may be only connected to the emitter 2. That is, the end of the extended doped layer 6 close to the emitter 2 is connected to the emitter 2, and there is a gap 9 between the end of the extended doped layer 6 close to the doped conductive layer 3 and the doped conductive layer 3. This structure can ensure that the solar cell 100 has a high current transmission effect in an abnormal state, while avoiding the influence of the extended doped layer 6 on the doped conductive layer 3, so as to ensure the current transmission performance of the solar cell 100 under the normal working state, thereby ensuring the performance of the solar cell 100.

In some embodiments, when the conductive type of the doping elements in the extended doped layer 6 is the same as those in the emitter 2, as shown in FIG. 2b, the end of the extended doped layer 6 close to the emitter 2 is connected to the emitter 2.

In some embodiments, the connection between the end of the extended doped layer 6 close to the emitter 2 and the emitter 2 can improve the current transmission efficiency of the solar cell 100 in an abnormal state, thereby further ensuring that the current of the solar cell string where the solar cell 100 is located can flow normally, so as to ensure that the photovoltaic module may keep working under the condition that only the power of the abnormal solar cell 100 is lost and maintain the normal working state.

In some embodiments, as shown in FIG. 2b, when the conductive type of the doping elements in the extended doped layer 6 is the same as those in the emitter 2, the extended doped layer 6 and the emitter 2 are integrally formed, that is, the extended doped layer 6 and the emitter 2 may be formed through the same process, which can reduce the process flow, thereby improving the preparation efficiency of the solar cell 100, facilitating the mass production of solar cells and saving costs.

For example, the substrate 1 is an N-type silicon substrate and the emitter 2 is formed by boron diffusion on the first surface 11. In the process of preparing the solar cell 100, first, the cell with boron silicon glass (BSG) on the surface of the emitter 2 may be subjected to single-sided HF acid washing. By controlling the acid washing process, only the contact surface with the liquid, that is, the second surface 12 of the substrate 1, is washed during the acid washing process, while 10% - 100% of the boron silicon glass (BSG) on the side surface is retained. Further, the area on the second surface 12 without the protection of boron silicon glass (BSG) may be etched to remove the unnecessary P-type doped layer. In addition, the emitter 2 is formed on the first surface 11 of the substrate 1 and the extended doped layer 6 is formed on the side of the substrate 1. The preparation process is simple and easy to implement, which further facilitates the mass production of solar cells and saves costs.

It is understandable that, the extended doped layer 6 may also be separately prepared from the emitter 2, which further improves the design freedom of the extended doped layer 6, facilitates the adjustment of the depth and concentration of the doping elements in the extended doped layer 6, thereby adjusting the leakage current at the extended doped layer 6, improving the leakage effect of the solar cell 100 and meeting the design requirements of the solar cell 100. The configuration may be specifically set according to actual requirements, and there is no limitation here.

In some embodiments shown in FIG. 2b, when the conductive type of the doping elements in the extended doped layer 6 is the same as those in the emitter 2, along the thickness direction Z, the extended doped layer 6 may be only connected to the emitter 2. That is, the end of the extended doped layer 6 close to the emitter 2 is connected to the emitter 2, and there is a gap 9 between the end of the extended doped layer 6 close to the doped conductive layer 3 and the doped conductive layer 3.

In some embodiments, as shown in FIG. 2b, the existence of the gap 9 between the end of the extended doped layer 6 close to the doped conductive layer 3 and the doped conductive layer 3 can ensure that the solar cell 100 has a high current transmission effect in an abnormal state, while avoiding the influence of the extended doped layer 6 on the doped conductive layer 3, so as to ensure the current transmission performance of the solar cell 100 under the normal working state, thereby ensuring the performance of the solar cell 100.

In some embodiments, when the conductive type of the doping elements in the extended doped layer 6 is the same as those in the emitter 2, along the thickness direction Z of the substrate 1, the extended doped layer 6 may also be only connected to the doped conductive layer 3. That is, the end of the extended doped layer 6 close to the doped conductive layer 3 is connected to the doped conductive layer 3, and there is a gap 9 between the end of the extended doped layer 6 close to the emitter 2 and the emitter 2. This structure can ensure that the solar cell 100 has a high current transmission effect in an abnormal state, while avoiding the influence of the extended doped layer 6 on the emitter 2, so as to ensure the current transmission performance of the solar cell 100 under the normal working state, thereby ensuring the performance of the solar cell 100.

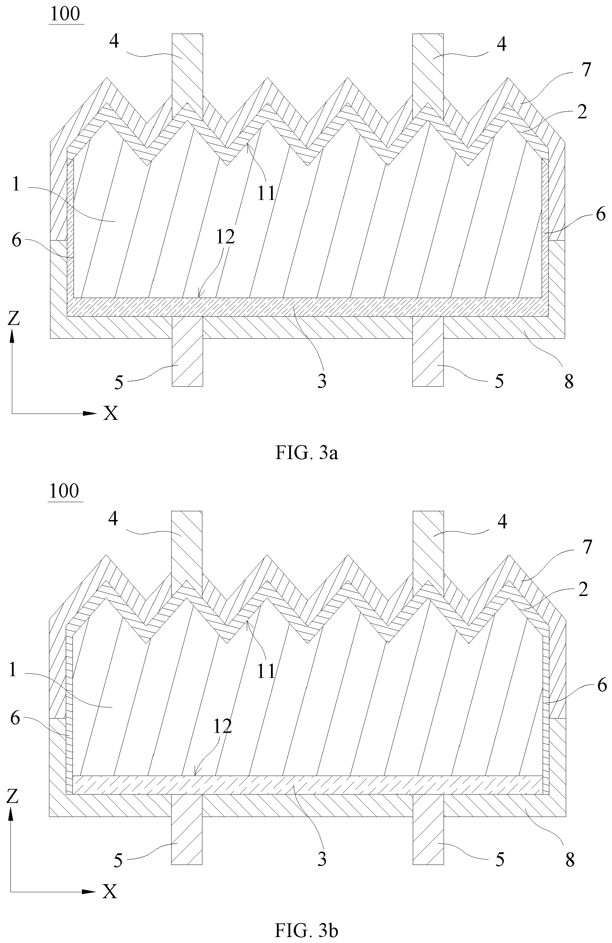

In some embodiments shown in FIG. 3a and FIG. 3b, along the thickness direction Z, the two ends of the extended doped layer 6 may be respectively connected to the adjacent emitter 2 and doped conductive layer 3. That is, the end of the extended doped layer 6 close to the doped conductive layer 3 is connected to the doped conductive layer 3, and the end of the extended doped layer 6 close to the emitter 2 is connected to the emitter 2.

As shown in FIG. 3a, when the conductive type of the doping elements in the extended doped layer 6 is the same as those in the doped conductive layer 3, such structure can form a short circuit between the extended doped layer 6 and the emitter 2, which is conducive to improving the leakage current at the extended doped layer 6. As shown in FIG. 3b, when the conductive type of the doping elements in the extended doped layer 6 is the same as those in the emitter 2, such structure can form a short circuit between the extended doped layer 6 and the doped conductive layer 3, which is conducive to improving the leakage current at the extended doped layer 6.

In some embodiments of the present disclosure, the structure as shown in FIG. 3a and FIG. 3b can form a short circuit between the extended doped layer 6 and the emitter 2 or the doped conductive layer 3, which is conducive to improving the leakage current at the extended doped layer 6, further improving the current transmission efficiency of the solar cell 100 in an abnormal state, thereby further ensuring that the current of the solar cell string where the solar cell 100 is located can flow normally. As a result, the photovoltaic module can keep working under the condition that only the power of the abnormal solar cell 100 is lost and maintain the normal working state.

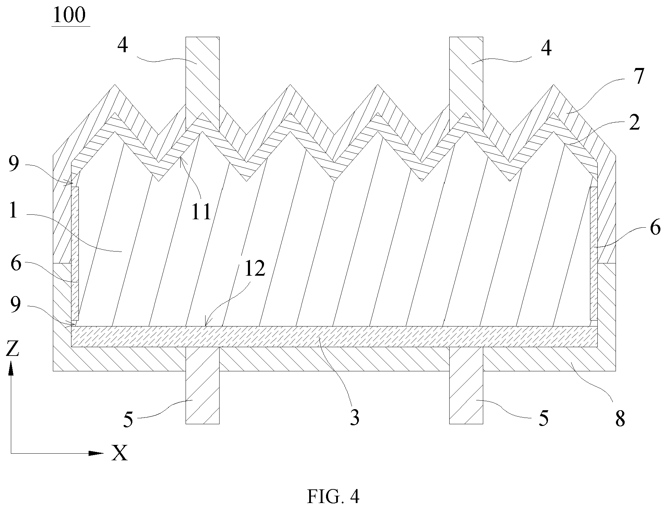

In some other embodiments shown in FIG. 4, along the thickness direction Z of the substrate 1, there are gaps 9 respectively between the two ends of the extended doped layer 6 and the emitter 2 as well as the doped conductive layer 3.

In some embodiments of the present disclosure, the structure as shown in FIG. 4 can ensure the current conduction effect of the solar cell 100 in an abnormal state, while avoiding the influence of the extended doped layer 6 on the doped conductive layer 3 and the emitter 2, so as to ensure the current transmission performance of the solar cell 100 under the normal working state and further improve the performance of the solar cell 100.

Among the above embodiments, the gap 9 may be the gap formed along the first direction X between the extended doped layer 6 and the emitter 2 or the doped conductive layer 3 as shown in FIG. 1b and FIG. 1b. The gap 9 may also be the gap formed along the thickness direction Z between the extended doped layer 6 and the emitter 2 and/or the doped conductive layer 3 as shown in FIG. 1a, FIG. 2a and FIG. 4, and there is no limitation here.

In addition, in the above embodiments, the gap 9 may be formed by etching, or by masking when the extended doped layer 6 and the doped conductive layer 3 are separately prepared, etc. There is no limitation here.

In some embodiments, as shown in FIG. 1, FIG. 2 and FIG. 4, a distance dimension of the gap 9 is between 0.5µm and 10µm. For example, the distance dimension of the gap 9 may be 0.5µm, 1µm, 2µm, 3µm, 4µm, 5µm, 6µm, 7µm, 8µm, 9µm, 10µm, etc. The distance may be specifically set according to actual requirements, and there is no limitation here.

As shown in FIG. 1a, FIG. 1b, FIG. 2a, in some embodiments, when the distance dimension of the gap 9 is between 0.5µm and 10µm, the proportion of the extended doped layer 6 on the side surface of the substrate 1 is moderate, it is easy to prepare and implement, and it can ensure that the solar cell 100 has a relatively high leakage current at the extended doped layer 6. Thus, it can ensure that the solar cell 100 may play the role of a resistive device when it is in an abnormal state, improving the current transmission effect of the solar cell 100, enabling the current of the solar cell string where the solar cell 100 is located to flow normally, and ensuring that the photovoltaic module can keep working under the condition that only the power of the abnormal solar cell 100 is lost and maintaining a normal working state. In some other embodiments, the distance dimension of the gap 9 may also have other ranges, which is not limited herein.

In some embodiments, as shown in FIG. 1a and FIG. 1b, the thickness of the extended doped layer 6 is d, and 0.05µm ≤ d ≤ 5µm. For example, d may be 0.05µm, 0.1µm, 0.5µm, 1µm, 2µm, 3µm, 4µm, 5µm, etc. Of course, d may also be other values within the above range. The thickness may be specifically set according to actual requirements, and there is no limitation here.

As shown in FIG. 1a and FIG. 1b, in some embodiments, when the thickness of the extended doped layer 6 satisfies 0.05µm ≤ d ≤ 5µm, the thickness of the extended doped layer 6 is proper, which can ensure that there is a relatively high leakage current at the extended doped layer 6, so that the solar cell 100 may play the role of a resistive device when it is in an abnormal state, enabling the current of the solar cell string where the solar cell 100 is located to flow normally, so that the photovoltaic module can maintain a normal working state. In addition, the photovoltaic module is easy to prepare, with low costs, and can also ensure the stable transmission of the current of the solar cell 100 under the normal working state. In some other embodiments, the thickness of the extended doped layer 6 may also have other ranges, which is not limited herein.

In some embodiments, as shown in FIG. 1a and FIG. 2a, when the conductive type of the doping elements in the extended doped layer 6 is the same as those in the doped conductive layer 3, the concentration of the doping elements in the extended doped layer 6 is similar as that in the doped conductive layer 3, which facilitates the formation of the extended doped layer 6 and the doped conductive layer 3 through the same process, thereby improving the preparation efficiency of the solar cell 100, and saving costs.

As shown in FIG. 1a and FIG. 2a, the concentration of the doping elements in the extended doped layer 6 is 1×10¹⁷ atoms/cm³ to 5×10²¹ atoms/cm³. For example, the concentration of the doping elements in the extended doped layer 6 may be 1≤10¹⁷ atoms/cm³, 2×10¹⁷ atoms/cm³, 3×10¹⁷ atoms/cm³, 4×10¹⁷ atoms/cm³, 5×10¹⁷ atoms/cm³, etc. It is understandable that, the concentration of the doping elements may also be other values within the above range. The concentration may be specifically set according to actual requirements, and there is no limitation here.

In some embodiments, as shown in FIG. 1a and FIG. 2a, when the conductive type of the doping elements in the extended doped layer 6 is the same as those in the doped conductive layer 3, and when the concentration of the doping elements is 1≤10¹⁷ atoms/cm³ to 5×10²¹ atoms/cm³, it is ensured that a stable high-low junction structure can be formed between the extended doped layer 6 and the substrate 1, so that there is a relatively high leakage current at the extended doped layer 6, which can ensure the stable transmission of the current of the solar cell 100 under the normal working state. In addition, the solar cell 100 may play the role of a resistive device when it is in an abnormal state, enabling the current of the solar cell string where the solar cell 100 is located to flow normally, so that the photovoltaic module can maintain a normal working state. In some other embodiments, the concentration of the doping elements may also have other ranges, which is not limited herein.

In some embodiments, as shown in FIG. 1b and FIG. 2b, when the conductive type of the doping elements in the extended doped layer 6 is the same as those in the emitter 2, the concentration of the doping elements in the extended doped layer 6 is similar as that in the emitter 2, which facilitates the formation of the extended doped layer 6 and the emitter 2 through the same process, thereby improving the preparation efficiency of the solar cell 100, and saving costs.

As shown in FIG. 1b and FIG. 2b, the concentration of the doping elements in the extended doped layer 6 is 1×10¹⁷ atoms/cm³ to 5×10²¹ atoms/cm³. For example, the concentration of the doping elements in the extended doped layer 6 may be 1≤10¹⁷ atoms/cm³, 2×10¹⁷ atoms/cm³, 3×10¹⁷ atoms/cm³, 4×10¹⁷ atoms/cm³, 5×10¹⁷ atoms/cm³, etc. It is understandable that, the concentration of the doping elements may also be other values within the above range. The concentration may be specifically set according to actual requirements, and there is no limitation here.

In some embodiments, as shown in FIG. 1b and FIG. 2b, when the conductive type of the doping elements in the extended doped layer 6 is the same as those in the emitter 2, and when the concentration of the doping elements is 1×10¹⁷ atoms/cm³ to 5×10²¹ atoms/cm³, it is ensured that a stable P-N junction structure can be formed between the extended doped layer 6 and the substrate 1, so that there is a relatively high leakage current at the extended doped layer 6, which can ensure the stable transmission of the current of the solar cell 100 under the normal working state. In addition, the solar cell 100 may play the role of a resistive device when it is in an abnormal state, enabling the current of the solar cell string where the solar cell 100 is located to flow normally, so that the photovoltaic module can maintain a normal working state. In some other embodiments, the concentration of the doping elements may also have other ranges, which is not limited herein.

In some embodiments, as shown in FIG. 1a to FIG. 4, the solar cell 100 further includes a first passivation layer 7 and a second passivation layer 8. The first passivation layer 7 is provided on a surface of the emitter 2 away from the substrate 1, and an edge of the first passivation layer 7 extends to a partial surface of the extended doped layer 6 away from the substrate 1. The second passivation layer 8 is provided on a surface of the doped conductive layer 3 away from the substrate 1, and an edge of the second passivation layer 8 extends to another partial surface of the extended doped layer 6 away from the substrate 1.

The first passivation layer 7 is provided on the surface of the emitter 2 away from the substrate 1. The first passivation layer 7 can achieve good passivation on the surface of the emitter 2 away from the substrate 1, and reduce the density of interface states, thereby reducing the recombination of minority carriers and improving the carrier transmission efficiency at the interface, and further improving the efficiency of the solar cell 100. The first passivation layer 7 may also have the functions of reducing or eliminating the reflected light on the surface of the solar cell and increasing the light transmittance, which further improves the photoelectric conversion efficiency of the solar cell. The first passivation layer 7 may be deposited by the plasma enhanced chemical vapor deposition method. It is understandable that, other methods may also be used, such as the organic chemical vapor deposition method, to form the first passivation layer 7. The first passivation layer 7 may be a single-layer structure or a stack-up structure, and the refractive index and thickness of each layer may be designed accordingly. For example, the first passivation layer 7 may be any one or a combination of multiple layers of a silicon nitride layer, a silicon oxynitride layer, and a silicon oxide layer. It is understandable that, the first passivation layer 7 may also adopt other types of passivation layers, and there is no limitation here.

The second passivation layer 8 is provided on the surface of the doped conductive layer 3 away from the substrate 1. The second passivation layer 8 can achieve good passivation on the surface of the doped conductive layer 3 away from the substrate 1, and reduce the density of interface states, thereby reducing the recombination of minority carriers and improving the carrier transmission efficiency at the interface, and further improving the efficiency of the solar cell 100. The second passivation layer 8 may be deposited by the plasma enhanced chemical vapor deposition method. It is understandable that, other methods may also be used, such as the organic chemical vapor deposition method, to form the second passivation layer 8. The second passivation layer 8 may be a single-layer structure or a stack-up structure, and the thickness of each layer may be designed accordingly. For example, the second passivation layer 8 may be any one or a combination of multiple layers of a silicon nitride layer, a silicon oxynitride layer, a silicon oxide layer, and aluminium oxide. It is understandable that, the second passivation layer 8 may also adopt other types of passivation layers, and there is no limitation here.

In some embodiments, as shown in FIG. 1a to FIG. 4, the edges of the first passivation layer 7 and the second passivation layer 8 can extend to the surface of the extended doped layer 6 away from the substrate 1, so that they can provide protection for the extended doped layer, prevent the extended doped layer 6 from being affected by pollutants, ensuring the uniformity and consistency of the leakage current at the extended doped layer 6. In addition, the first passivation layer 7 and the second passivation layer 8 can achieve good passivation on the surface of the extended doped layer 6 to prevent the leakage current from being excessively high, which avoids affecting the current transmission performance of the solar cell 100 under the normal working state, thereby improving the performance of the solar cell 100.

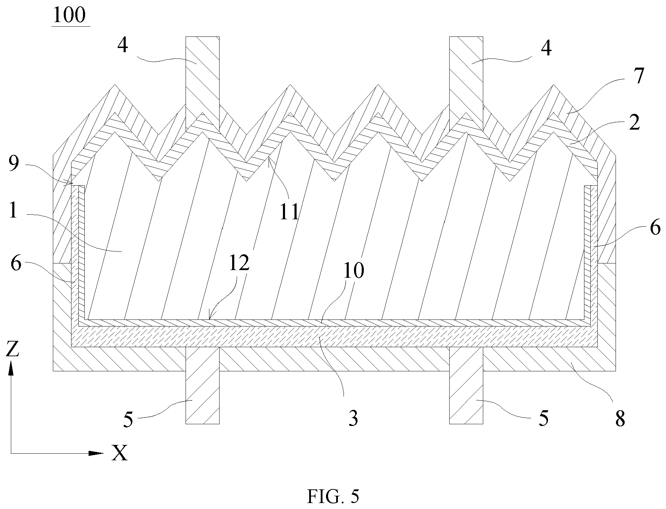

In some embodiments, as shown in FIG. 5, when the solar cell 100 is a TOPCon cell, the solar cell 100 further includes a tunneling layer 10, and the tunneling layer 10 is provided between the substrate 1 and the doped conductive layer 3 as well as between the substrate 1 and the extended doped layer 6.

In some embodiments, as shown in FIG. 5, the tunneling layer 10 reduces the density of interface states between the substrate 1 and the doped conductive layer 3 through chemical passivation, reduces the recombination of minority carriers and holes, and improves the passivation effect on the second surface 12 and the side surface of the substrate 1. The tunneling layer 10 can enable the majority carriers to tunnel into the doped conductive layer 3, and then the majority carriers can be transmitted laterally within the doped conductive layer 3, which is conducive to the carrier collection by the second electrode 5, thereby greatly reducing the contact recombination current between the second electrode 5 and the doped conductive layer 3 and thus improving the open-circuit voltage and short-circuit current of the solar cell.

In some embodiments, the materials of the tunneling layer 10 may include, but is not limited to, a single-layer or stack-up structure made of one or more of dielectric materials with tunneling effects, such as silicon oxide, silicon nitride, silicon oxynitride, intrinsic amorphous silicon, and intrinsic polycrystalline silicon. In some other embodiments, the tunneling layer 10 may also be a silicon oxynitride layer containing oxygen, a silicon carbide layer containing oxygen, etc. The tunneling layer 10 may be an ultra-thin silicon oxide layer, and its thickness may generally be between 0.5 nm and 3 nm. The thickness may be specifically set according to actual requirements, and there is no limitation here. In some embodiments, the tunneling layer 10 may be formed on the second surface 12 of the substrate 1 by using the ozone oxidation method, the high-temperature thermal oxidation method, the nitric acid oxidation method, the chemical vapor deposition method, or the low-pressure chemical vapor deposition method.

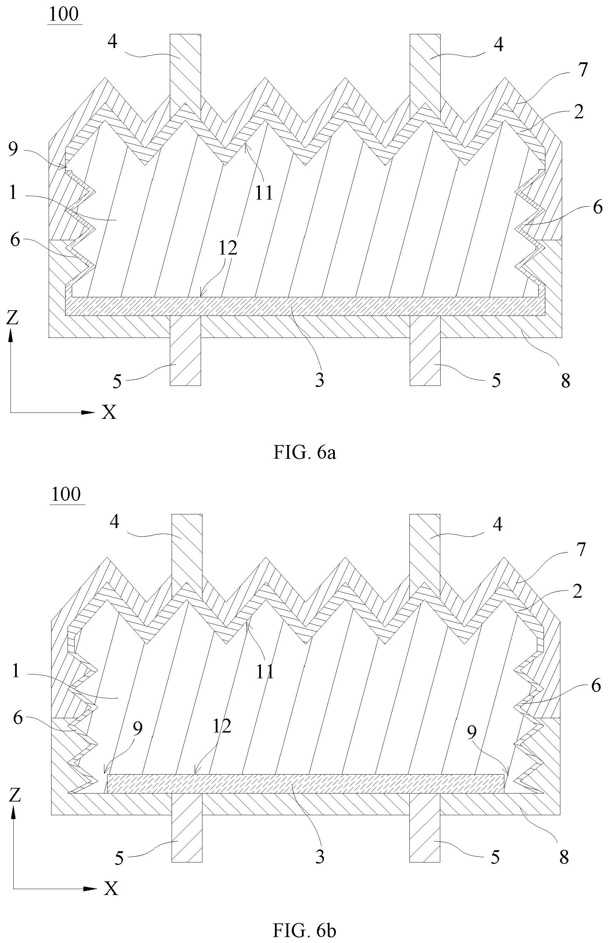

In some embodiments, as shown in FIG. 6a and FIG. 6b, the surface of the extended doped layer 6 is a flat platform structure or a textured structure.

The surface of the extended doped layer 6 may be a flat platform structure as shown in FIG. 1a to FIG. 5, or the surface of the extended doped layer 6 may also be a textured structure as shown in FIG. 6a and FIG. 6b. For example, the surface of the extended doped layer 6 may be a pyramid-like structure such as a pyramid or a cone. It is understandable that, the surface of the extended doped layer 6 may also be a combination of a flat platform structure and a textured structure, so as to facilitate the adjustment of the leakage current of the extended doped layer 6 and further improve the design freedom of the extended doped layer 6 to meet the design requirements of different solar cells 100, and there is no limitation here.

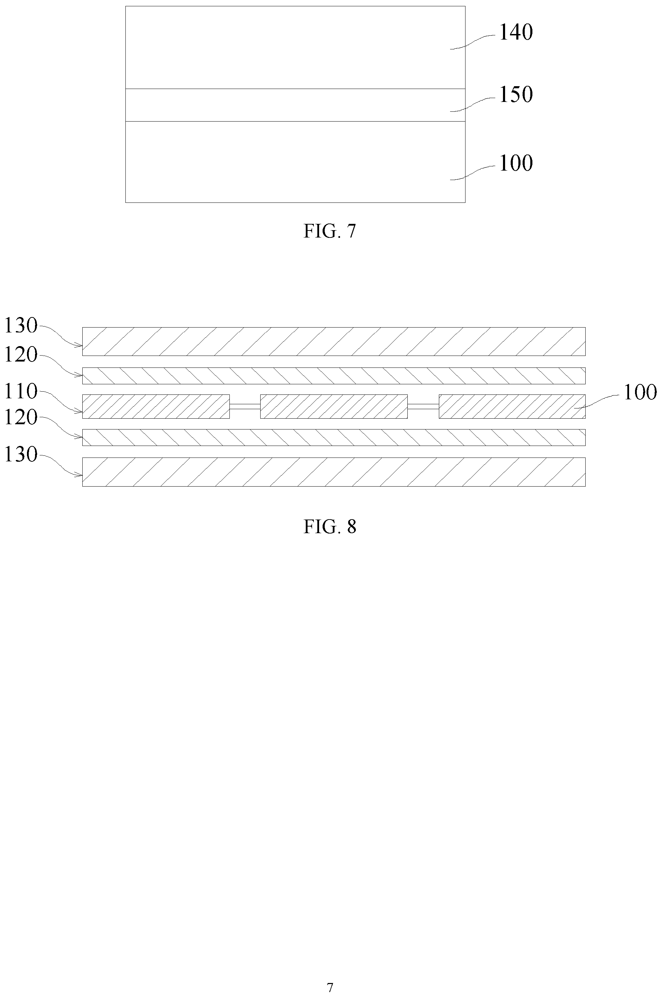

The present disclosure also provides a tandem cell (tandem solar cell). As shown in FIG. 7, the tandem cell includes a bottom cell, a top cell 140, and an intermediate connection layer 150. The bottom cell is the solar cell 100 in any of the above embodiments. The top cell 140 is one of a perovskite solar cell, a donor-acceptor solar cell, a cadmium telluride (CdTe) solar cell, a copper indium gallium selenide (CIGS) solar cell, and a gallium arsenide (GaAs) solar cell. The intermediate connection layer 150 is electrically connected between the bottom cell and the top cell 140. Since the solar cell 100 has the above-mentioned technical effects, the tandem cell including the solar cell 100 should also have the above-mentioned technical effects, and details will not be repeated here.

As shown in FIG. 7, the bandgap width of the top cell 140 is wider than that of the bottom cell. Therefore, superimposing the top cell 140 above the bottom cell can make the tandem cell have a wider spectral response range, thereby maximizing the utilization of solar energy and improving the efficiency of the solar cell.

The intermediate connection layer 150 is generally a tunnel junction or a very thin metal or transparent electrode composite layer. For example, the intermediate connection layer 150 may be transparent conductive oxides (TCOs). transparent conductive oxides (TCOs) have good photoelectric characteristics, high photon transmittance and relatively high conductivity, so that the top cell 140 and the bottom cell can maintain good ohmic contact.

When the solar cell 100 is the bottom cell, the first electrode 4 or the second electrode 5 of the solar cell 100 may also be used as the intermediate connection layer 150 to achieve electrical connection with the top cell 140. In addition, when the solar cell 100 is the bottom cell, the passivation layer and the electrode on the side where the solar cell 100 is connected to the top cell 140 may also be removed, or the passivation layer and the electrode on this side are not prepared, so that the solar cell 100 is connected to the top cell 140 through the intermediate connection layer 150.

The present disclosure also provides a photovoltaic module. As shown in FIG. 8, the photovoltaic module includes a solar cell string 110, an encapsulation layer 120, and a cover plate 130. The solar cell string 110 is formed by connecting a plurality of solar cells 100 as described in any of the above embodiments. The encapsulation layer 120 is used to cover the surface of the solar cell string 110, and the cover plate 130 is used to cover the surface of the encapsulation layer 120 away from the solar cell string 110. Since the solar cell 100 has the above-mentioned technical effects, the photovoltaic module including the solar cell 100 should also have the above-mentioned technical effects, and details will not be repeated here.

As shown in FIG. 8, the solar cells 100 are electrically connected in the form of the whole cell or multiple cut cells to form multiple solar cell strings 110. Multiple solar cell strings 110 are electrically connected in series and/or in parallel. For example, multiple solar cell strings 110 may be electrically connected through conductive strips. The encapsulation layer 120 covers the front and back surfaces of the solar cells. The encapsulation layer 120 may be an organic encapsulation film such as an ethylene-vinyl acetate copolymer (EVA) film, a polyethylene octene copolymer elastomer (POE) film, a polyethylene terephthalate (PET) film, or a polyvinyl butyral (PVB) film. The cover plate 130 may be a glass cover plate, a plastic cover plate, or other cover plates 130 with light-transmitting functions. The surface of the cover plate 130 facing the encapsulation layer 120 may be a concave-convex surface, so as to increase the utilization rate of incident light.

The above is only the specific implementation manners of the embodiments of the present disclosure, but the protection scope of the embodiments of the present disclosure is not limited thereto. Therefore, the protection scope of the embodiments of the present disclosure should be subject to the protection scope of the appended claims.

## Claims

1. A solar cell, comprising:
a substrate including a first surface and a second surface opposite to each other;
an emitter formed in or on the first surface of the substrate along a thickness direction of the substrate;
a doped conductive layer formed in or on the second surface of the substrate along the thickness direction of the substrate;
a first electrode formed on a surface of the emitter away from the substrate and electrically connected to the emitter;
a second electrode formed on a surface of the doped conductive layer away from the substrate and electrically connected to the doped conductive layer; and
an extended doped layer formed on at least one side surface of the substrate in a direction perpendicular to the thickness direction, wherein the extended doped layer and the doped conductive layer or the emitter have doping elements of the same type.

2. The solar cell according to claim 1, wherein an end of the extended doped layer close to the doped conductive layer is connected to the doped conductive layer.

3. The solar cell according to claim 2, wherein the extended doped layer and the doped conductive layer are integrally formed.

4. The solar cell according to claim 2, wherein a gap is provided between the emitter and an end of the extended doped layer close to the emitter.

5. The solar cell according to claim 1, wherein an end of the extended doped layer close to the emitter is connected to the emitter.

6. The solar cell according to claim 5, wherein the extended doped layer and the emitter are integrally formed.

7. The solar cell according to claim 5, wherein a gap is formed between an end of the extended doped layer close to the doped conductive layer and the doped conductive layer.

8. The solar cell according to claim 1, wherein along the thickness direction of the substrate, a gap is respectively provided between one of two ends of the extended doped layer and the emitter and between the other one of the two ends of the extended doped layer and the doped conductive layer.

9. The solar cell according to claim 4 or 7 or 8, wherein a distance dimension of the gap is in a range of 0.5µm to 10µm.

10. The solar cell according to any one of claims 1 to 8, wherein a thickness of the extended doped layer is d, and 0.05µm ≤ d ≤ 5µm.

11. The solar cell according to any one of claims 1 to 5, wherein the extended doped layer and the doped conductive layer have doping elements of the same type, and the doping element in the extended doped layer and the doping element in the doped conductive layer have similar doping concentration.

12. The solar cell according to any one of claims 1 to 8, wherein the doping concentration of the doping element in the extended doped layer is 1×10¹⁷ atoms/cm³ to 5×10²¹ atoms/cm³.

13. The solar cell according to any one of claims 1 to 8, wherein the solar cell further comprises:
a first passivation layer formed on a surface of the emitter away from the substrate, and an edge of the first passivation layer extending to a part of a surface of the extended doped layer away from the substrate; and
a second passivation layer formed on a surface of the doped conductive layer away from the substrate, and an edge of the second passivation layer extending to another part of the surface of the extended doped layer away from the substrate, and/or
wherein the solar cell further comprises:
a tunneling layer formed between the substrate and the doped conductive layer as well as between the substrate and the extended doped layer.

14. A tandem cell, comprising:
a bottom cell, the bottom cell being the solar cell according to any one of claims 1 to 13;
a top cell, the top cell being one of a perovskite solar cell, a donor-acceptor solar cell, a cadmium telluride solar cell, a copper indium gallium selenide solar cell or a gallium arsenide solar cell; and
an intermediate connection layer electrically connected between the bottom cell and the top cell.

15. A photovoltaic module, comprising:
at least one solar cell string formed by connecting a plurality of the solar cells according to any one of claims 1 to 13;
an encapsulation layer configured to cover a surface of the at least one solar cell string; and
a cover plate configured to cover a surface of the encapsulation layer away from the at least one solar cell string.
